# EUROPÄISCHE PATENTSCHRIFT

(11) **EP 3 479 664 B1**
(45) Veröffentlichungstag und Bekanntmachung des Hinweises auf die Patenterteilung: **20.10.2021**
(21) Anmeldenummer: 17726204.5
(22) Anmeldetag: 09.05.2017
(51) Int. Cl.: H05K 5/00

(54) **VERFAHREN ZUM HERSTELLEN EINER STEUERGERÄTEEINHEIT, INSBESONDERE FÜR EIN FAHRZEUG, UND STEUERGERÄTEINHEIT, INSBESONDERE FÜR EIN FAHRZEUG**
METHOD FOR PRODUCING A CONTROL UNIT, IN PARTICULAR FOR A VEHICLE, AND CONTROL UNIT, IN PARTICULAR FOR A VEHICLE
PROCÉDÉ DE FABRICATION D'UNE UNITÉ APPAREIL DE COMMANDE, EN PARTICULIER POUR UN VÉHICULE, ET UNITÉ APPAREIL DE COMMANDE, EN PARTICULIER POUR UN VÉHICULE

(30) Priorität: 30.06.2016 DE 102016211863
(43) Veröffentlichungstag der Anmeldung: 08.05.2019
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2017/061043
(87) Internationale Veröffentlichungsnummer: WO 2018/001611

(56) Entgegenhaltungen:
- WO-A1-2009/130156
- DE-A1- 4 136 381
- DE-A1- 19 755 765
- DE-A1-102014 007 443
- DE-A1-102015 101 791

## Beschreibung

### Gebiet der Erfindung

Die Erfindung betrifft ein Verfahren zum Herstellen einer Steuergeräteeinheit, insbesondere für ein Fahrzeug, und eine Steuergeräteinheit, insbesondere für ein Fahrzeug.

### Stand der Technik

Steuergeräteeinheiten werden oft in einer Ölumgebung oder auch in feuchter Umgebungsluft eingesetzt. Dies bedeutet, dass der Innenraum bzw. das Innenvolumen der Steuergeräteeinheit öldicht oder feuchtedicht gegenüber der Umgebung abgedichtet sein muss.

Bisher bekannte Steuergeräteeinheiten umfassen üblicherweise einen Gehäuseboden, ein Steckeraufnahmeelement zum Aufnehmen und Anschließen eines Steckers an die Steuergeräteeinheit und einen Gehäusedeckel. Diese Elemente umschließen zusammen den Innenraum, in dem in der Regel ein Leiterplattenelement angeordnet ist. Auf dem Leiterplattenelement sind elektrische Bauelemente angeordnet. Zudem sind Steckerpins vorhanden, die in das Steckeraufnahmeelement hineinragen und jeweils mit einem oder mehreren der elektrischen Bauelemente verbunden sind.

Bei bisher bekannten Steuergeräteeinheiten wird das Leiterplattenelement mittels mehrerer Schrauben und/oder mittels mehrerer Bolzen an dem Gehäuseboden befestigt. Zudem wird der Gehäusedeckel mittels einer oder mehrerer Schrauben und/oder mittels eines oder mehrerer Bolzen an dem Gehäuseboden befestigt. Auch wird hierbei eine Einlegedichtung zum Abdichten der Verbindung zwischen Gehäuseboden und Gehäusedeckel benötigt. Somit weisen bisher bekannte Steuergeräteeinheiten in der Regel eine Vielzahl von Bauteilen auf. Auch wird üblicherweise eine große Anzahl von Fertigungsschritten bei der Herstellung der Steuergeräteeinheit benötigt.

Aus der DE 10 2014 007 443 A1 ist Verfahren zur Herstellung einer Steuergeräteeinheit bekannt, bei dem ein Leiterplattenelement mit darin eingebetteten Steckerpins, welche sich durch Aufnahmeöffnungen eines Steckeraufnahmeelements erstrecken, in einem Gehäusebodenelement vergossen wird. Eine Gehäusedeckel wird auf das Gehäusebodenelement derart aufgesetzt, dass der Gehäusedeckel und Gehäusebodenelement und das Steckeraufnahmeelement zusammen das Leiterplattenelement umschließen.

### Offenbarung der Erfindung

### Vorteile der Erfindung

Ausführungsformen der vorliegenden Erfindung können in vorteilhafter Weise ermöglichen, eine öldichte oder feuchtedichte Steuergeräteeinheit aus wenigen Einzelteilen bzw. Bauteilen in wenigen Fertigungsschritten herzustellen.

Gemäß einem ersten Aspekt der Erfindung wird ein Verfahren zum Herstellen einer Steuergeräteeinheit, insbesondere für ein Fahrzeug, vorgeschlagen, folgende Schritte umfassend: Bereitstellen eines Gehäusebodenelements; Bereitstellen eines Steckeraufnahmeelements zum Aufnehmen eines Steckers, wobei das Steckeraufnahmeelement in einem Aufnahmeöffnungsbereich Aufnahmeöffnungen für Steckerpins aufweist; Bereitstellen eines Leiterplattenelements, wobei das Leiterplattenelement elektrische Bauelemente auf einer Montagefläche und in dem Leiterplattenelement befestigte Steckerpins umfasst, wobei die Steckerpins aus einem Steckerpinbereich des Leiterplattenelements hervorstehen; Anordnen des Leiterplattenelements auf dem Gehäusebodenelement und auf dem Steckeraufnahmeelement derart, dass sich die Steckerpins durch die Aufnahmeöffnungen des Steckeraufnahmeelements erstrecken; Aufbringen eines zweiten Dammmaterials auf das Steckeraufnahmeelement und auf eine der Seite des Steckerpinbereichs gegenüberliegende Seite des Leiterplattenelements; und Anordnen eines Gehäusedeckels derart, dass der Gehäusedeckel, das Gehäusebodenelement und das Steckeraufnahmeelement zusammen das Leiterplattenelement umschließen und der Gehäusedeckel mit dem Steckeraufnahmeelement mittels des zweiten Dammmaterials öldicht und feuchtedicht verbunden ist, Aufbringen eines ersten Dammmaterials auf das Steckeraufnahmeelement zumindest teilweise, insbesondere vollständig, um den Aufnahmeöffnungsbereich des Steckeraufnahmeelements herum oder auf den Steckerpinbereich des Leiterplattenelements, wobei das erste und zweite Dammmaterial (70, 80) ausgehärtet wird, nachdem der Gehäusedeckel (40) angeordnet wurde, und wobei das Steckeraufnahmeelement (30) senkrecht zu dem Gehäusebodenelement (20) verläuft und das Leiterplattenelement (50) zwei Teilbereiche hat, die einen Winkel von ca. 90° zueinander aufweisen.

Ein Vorteil hiervon ist, dass die öldichte oder feuchtedichte Steuergeräteeinheit in der Regel technisch einfach aufgebaut ist und aus wenigen Einzelteilen hergestellt wird. Darüber hinaus werden üblicherweise nur wenige Fertigungsschritte benötigt, so dass die Herstellung üblicherweise technisch einfach und schnell durchführbar ist. Insbesondere werden im Allgemeinen keine mechanischen Befestigungen (Schrauben, Bolzen oder ähnliches) benötigt, um den Gehäusedeckel öldicht mit dem Gehäusebodenelement und dem Steckeraufnahmeelement zu verbinden. Zudem werden in der Regel keine Einlegedichtungen und keine Druckausgleichselemente benötigt. Im Allgemeinen kann das Leiterplattenelement große Toleranzen aufweisen, da keine mechanischen Befestigungspunkte bzw. Schraubpunkte oder direkte Kühlbalkonkontakte benötigt werden bzw. vorhanden sind. Ein weiterer Vorteil ist, dass das Leiterplattenelement maximal eine gesonderte Befestigung, z.B. mit einer Kunststoffniete oder einem Kunststoffverrastungselement, bzw. gar keine Befestigung mittels eines mechanischen Elements benötigt. Auch wird bei diesem Verfahren üblicherweise der Steckerpinbereich technisch einfach öldicht abgedichtet.

Das (erste und oder zweite) Dammmaterial weist eine derart hohe Viskosität auf, dass, auch beim Erhitzen und Vernetzen des Dammmaterials, das Dammmaterial seine Form behält, also nicht (weg)fließt. Das Dammmaterial kann z.B. ein Epoxidharzmaterial sein. Das erste Dammmaterial und/oder das zweite Dammmaterial kann pastenartig ausgebildet sein.

Das Füllmaterial ist niederviskos (niederviskoser als das Dammmaterial), so dass es spätestens beim Erwärmen und Vernetzen (noch) dünnflüssiger wird und folglich nahezu eben verläuft. Das Füllmaterial kann aus der gleichen Materialgruppe wie das Dammmaterial sein. Vorstellbar ist auch, dass Füllmaterial und Dammmaterial aus einer anderen Materialgruppe sind. Das erste Dammmaterial und das zweite Dammmaterial kann das gleiche Dammmaterial bzw. Material aufweisen. Vorstellbar sind auch, dass das erste Dammmaterial und das zweite Dammmaterial zueinander unterschiedliche Materialien aufweisen.

Das Dammmaterial und/oder das Füllmaterial können ein- oder zweikomponentige, thermisch härtende Polymersysteme (1K, 2K) sein, insbesondere solche basierend auf Epoxidharzen, Polyurethanen, Silikon oder Acrylat. Das Aushärten kann z.B. mit UV-Strahlung durchgeführt werden, insbesondere wenn die UV-Strahlung große Flächen bzw. Volumen des Dammmaterials bzw. des Füllmaterials erreicht. Das Dammmaterial und/oder das Füllmaterial können Hybridwerkstoffe sein, die durch partielle UV-Bestrahlung, d.h. UV-Bestrahlung nur eines Teilbereichs, mit der Vernetzung beginnen und dann ohne weitere Bestrahlung auch in nicht bestrahlte Gebiete (Schattenbereiche) weiter hinein vernetzen. Epoxidharz erfüllt die Anforderungen an Temperatur- und Medienbeständigkeit und lässt sich auf einen Wärmeausdehnungskoeffizienten einstellen, der dem Wärmeausdehnungskoeffizienten des Leiterplattenelements entspricht. Mittels Füllstoffen kann die Wärmeleitfähigkeit erhöht werden. Epoxidharze können einen (z.B. durch Füllstoffe) einstellbaren Wärmeausdehnungskoeffizienten von ca. 15 ppm/K bis ca. 30 ppm/K aufweisen. Mittels des Epoxidharzes können delaminationsfrei sowohl das Leiterplattenelement als auch der Gehäusedeckel und das Gehäusebodenelement mit ausreichender Adhäsion verbunden werden. Die Wärmeleitfähigkeit des Epoxidharzes kann im Bereich von ca. 0,5 W/mK bis ca. 5 W/mK betragen, so dass in der Regel eine gute Wärmeanbindung zwischen den elektrischen Bauelementen, dem Leiterplattenelement und dem Gehäusedeckel und/oder dem Gehäusebodenelement herstellbar ist.

Ideen zu Ausführungsformen der vorliegenden Erfindung können unter anderem als auf den nachfolgend beschriebenen Gedanken und Erkenntnissen beruhend angesehen werden.

Das Verfahren kann ferner folgenden Schritt umfassen: Aufbringen eines Füllmaterials auf das Leiterplattenelement, wobei der Gehäusedeckel derart angeordnet wird, dass der Gehäusedeckel, das Gehäusebodenelement und das Steckeraufnahmeelement zusammen das Leiterplattenelement umschließen und der Gehäusedeckel mit dem Gehäusebodenelement mittels des Füllmaterials öldicht verbunden ist und der Gehäusedeckel mit dem Steckeraufnahmeelement mittels des zweiten Dammmaterials öldicht und feuchtedicht verbunden ist. Ein Vorteil hiervon ist, dass in der Regel Lötverbindungen auf dem Leiterplattenelement (elektrische Bauelemente und Steckerpins) durch das Füllmaterial vor Zerrüttung geschützt werden. Die elektrischen Bauelemente sind in der Regel durch zumindest teilweise Einbettung in dem Füllmaterial schock- und schwingungsstabilisiert. Auch wird üblicherweise entstehende Wärme in den elektrischen Bauelementen durch das Füllmaterial besonders gut weggetragen (verbesserte Wärmespreizung an den elektrischen Bauelementen und Wärmepufferung). Darüber hinaus können in der Regel elektrische Bauelemente verwendet werden, die geringere Spezifikationen bzw. eine geringere Qualität bzw. eine höhere Empfindlichkeit in Bezug auf Wärme haben, da die Wärme besonders gut weggetragen wird, wodurch sich die elektrischen Bauelemente weniger stark erwärmen und folglich weniger schnell altern. Dadurch dass das Füllmaterial auf dem Leiterplattenelement aufgebracht wird und die elektrischen Bauelemente zumindest teilweise davon umschlossen werden, kann typischerweise auf zusätzliche Wärmeleitkleber, auf Aushärteprozesse für die Anbindung bzw. Verbindung des Leiterplattenelements an Kühlflächen, auf Toleranzausgleichselemente und Wärmeleitkleber an den elektrischen Bauelementen mit Slug-up-Entwärmung verzichtet werden. Dies vereinfacht den Herstellungsprozess. Das Füllmaterial verhindert typischerweise zudem potentielle Kurz- oder Nebenschlüsse auf dem Leiterplattenelement durch Metallflitter bzw. Metallspäne, die bei der Fertigung des Gehäusedeckels oder des Gehäusebodenelements entstanden sind. Sofern sich solche Partikel bereits auf dem Leiterplattenelement befinden sollten, werden diese in der Regel durch das Füllmaterial an ihrer jeweiligen Position festgehalten bzw. "eingefroren". Die Steuergeräteeinheiten, die Fehler aufgrund der festgehaltenen Metallspäne bzw.

Metallflitter zeigen, können typischerweise in der Schlussprüfung erkannt und aussortiert werden. Ein weiterer Vorteil ist, dass in der Regel Kriechströme vermieden werden können, w weil keine salzhaltige Luft in das Steuergerät eindringen kann und somit keine Überhitzung der Leiterplatte durch unzulässige Kriechströme erfolgen kann. Auch müssen bestimmte Layout-Regeln und Mindestleiterbahnabstände typischerweise nicht zwingend eingehalten werden, um die feuchtbedingten Kriechströme zu vermeiden. Darüber hinaus ist ein Vorteil, dass typischerweise technisch einfache und kostengünstige Keramikkondensatoren bzw. MLCC-Typen verwendet werden können, auch an Dauer-Plus-Leitungen. Durch das Füllmaterial kann in der Regel an die MLCC-Typen kein Sauerstoff gelangen, so dass bei Überhitzung keine Reaktion mit Luftsauerstoff entstehen kann. Auch entstehen üblicherweise keine mechanischen bzw. thermomechanischen Spannungen in der Steuergeräteeinheit, da das Füllmaterial und/oder das Dammmaterial drucklos aufgebracht wird und im Vernetzungsprozess so geführt werden kann, dass nur ein sehr geringer Schrumpf entsteht sowie der Wärmeausdehnungskoeffizient dem des Leiterplattenelements entspricht. Folglich gibt es typischerweise keine Größenbeschränkung für die Steuergeräteeinheit. Bei einem geknickten bzw. L-förmigen Leiterplattenelement kann der Knickbereich in der Regel durch das Füllmaterial geschützt werden, insbesondere können auch eventuell freiliegende Kupfer-Bahnen-Bereiche dadurch geschützt werden. Auch brauchen Spulen und elektrische Kondensatoren in der Regel keine zusätzlichen Klipse oder Halter zur sicheren Befestigung an dem Leiterplattenelement.

Bei dem Verfahren kann zuerst der Gehäusedeckel angeordnet werden und dann über eine Einfüllöffnung im Gehäusedeckel Füllmaterial in den vom Gehäusedeckel, dem Gehäusebodenelement und dem Steckeraufnahmeelement umschlossenen Innenraum eingebracht werden, insbesondere solange bis Füllmaterial aus einer Steigeröffnung in dem Gehäusedeckel gelangt. Hierdurch kann in der Regel technisch einfach Füllmaterial in den Innenraum eingebracht werden, nachdem der Gehäusedeckel aufgesetzt bzw. angeordnet wurde. Bei einer vollständigen Füllung des Innenraums mit Dammmaterial und Füllmaterial wird üblicherweise eine hohe Steifigkeit der Steuergeräteeinheit erreicht.

Das Füllmaterial und/oder das erste und zweite Dammmaterial kann ausgehärtet werden, nachdem der Gehäusedeckel angeordnet wurde. Hierdurch wird der Herstellungsprozess in der Regel technisch noch weiter vereinfacht. Auch wird üblicherweise nur ein Aushärteprozess benötigt.

Das Steckeraufnahmeelement verläuft senkrecht zu dem Gehäusebodenelement und das Leiterplattenelement hat zwei Teilbereiche, die einen Winkel von ca. 90° zueinander aufweisen, insbesondere kann das Leiterplattenelement eine L-förmige Querschnittsform aufweisen. Ein Vorteil hiervon ist, dass das Leiterplattenelement in der Regel technisch einfach in dem Gehäuseboden angeordnet und befestigt werden kann. Zudem wird hierdurch typischerweise das Anschließen eines Steckers in dem Steckeraufnahmebereich vereinfacht.

Das Steckeraufnahmeelement kann einstückig mit dem Gehäusebodenelement ausgebildet sein. Hierdurch sinkt typischerweise die Anzahl der Bauteile der Steuergeräteeinheit. Somit wird in der Regel der Herstellungsprozess bzw. das Herstellungsverfahren weiter vereinfacht.

Der Gehäusedeckel und/oder das Gehäusebodenelement kann bzw. können jeweils eine Metalleinlage aufweisen. Ein Vorteil hiervon ist, dass typischerweise elektromagnetische Strahlung beim Austreten aus der Steuergeräteeinheit und beim Eindringen in die Steuergeräteeinheit gedämpft wird, so dass die elektromagnetische Verträglichkeit der Steuergeräteeinheit verbessert wird.

Gemäß einem zweiten Aspekt der Erfindung wird eine Steuergeräteeinheit, insbesondere für ein Fahrzeug, vorgeschlagen, umfassend: ein Gehäusebodenelement; ein Steckeraufnahmeelement zum Aufnehmen eines Steckers, wobei das Steckeraufnahmeelement in einem Aufnahmeöffnungsbereich Aufnahmeöffnungen für Steckerpins aufweist; einen Gehäusedeckel, und ein Leiterplattenelement, wobei das Leiterplattenelement elektrische Bauelemente auf einer Montagefläche und in dem Leiterplattenelement befestigte Steckerpins umfasst, wobei die Steckerpins aus einem Steckerpinbereich des Leiterplattenelements hervorstehen, wobei das Leiterplattenelement (50) auf dem Gehäusebodenelement (20) und auf dem Steckeraufnahmeelement (30) derart angeordnet ist, dass sich die Steckerpins (37, 38, 39) durch die Aufnahmeöffnungen (60) des Steckeraufnahmeelements (30) erstrecken,
wobei ein zweiten Dammmaterials (80) auf das Steckeraufnahmeelement (30) und auf eine der Seite des Steckerpinbereichs gegenüberliegende Seite des Leiterplattenelements (50) aufgebracht ist und
wobei der Gehäusedeckel (40), das Gehäusebodenelement (20) und das Steckeraufnahmeelement (30) zusammen das Leiterplattenelement (50) umschließen, und der Gehäusedeckel (40) mit dem Steckeraufnahmeelement (30) mittels des zweiten Dammmaterials (80) öldicht verbunden ist wobei ein erstes Dammmaterials (70) auf das Steckeraufnahmeelement (30) zumindest teilweise, insbesondere vollständig, um den Aufnahmeöffnungsbereich (36) des Steckeraufnahmeelements (30) herum oder auf den Steckerpinbereich des Leiterplattenelements (50) aufgebracht ist, wobei das Steckeraufnahmeelement (30) senkrecht zu dem Gehäusebodenelement (20) verläuft und das Leiterplattenelement (50) zwei Teilbereiche hat, die einen Winkel von ca. 90° zueinander aufweisen.

Ein Vorteil hiervon ist, dass die öldichte und feuchtedichte Steuergeräteeinheit in der Regel technisch einfach aufgebaut ist und aus wenigen Einzelteilen herstellbar ist. Darüber hinaus werden üblicherweise nur wenige Fertigungsschritte benötigt, so dass die Herstellung üblicherweise technisch einfach und schnell durchführbar ist. Insbesondere werden im Allgemeinen keine mechanischen Befestigungen (Schrauben, Bolzen oder ähnliches) benötigt, um den Gehäusedeckel öldicht mit dem Gehäusebodenelement und dem Steckeraufnahmeelement zu verbinden. Zudem werden in der Regel keine Einlegedichtungen und keine Druckausgleichselemente benötigt.

Der Innenraum kann derart vollständig mit Dammmaterial und/oder Füllmaterial gefüllt sein, dass im Wesentlichen keine Hohlräume in dem Innenraum mehr vorhanden sind. Hierdurch ergibt sich im Regelfall eine hohe Steifigkeit der Steuergeräteeinheit.

Das Leiterplattenelement kann zwei Teilbereiche aufweisen, die zueinander einen Winkel von ca. 90° bilden. Ein Vorteil hiervon ist, dass das Leiterplattenelement in der Regel technisch einfach in dem Gehäuseboden angeordnet und befestigt ist. Zudem wird hierdurch typischerweise das Anschließen eines Steckers in dem Steckeraufnahmebereich vereinfacht.

Es wird darauf hingewiesen, dass einige der möglichen Merkmale und Vorteile der Erfindung hierin mit Bezug auf unterschiedliche Ausführungsformen beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
- Fig. 1 zeigt: eine schematische Querschnittsansicht eines Gehäusebodenelements und eines Steckeraufnahmeelements mit aufgebrachtem erstem Dammmaterial;
- Fig. 2 zeigt: eine schematische Querschnittsansicht des Gehäusebodenelements und des Steckeraufnahmeelements aus Fig. 1 nach Anordnen des Leiterplattenelements und dem Aufbringen des zweiten Dammmaterials;
- Fig. 3 zeigt: eine schematische Querschnittsansicht eines Gehäusebodenelements und eines Steckeraufnahmeelements, wobei das erste Dammmaterial auf einen Steckerpinbereich aufgebracht worden ist;
- Fig. 4 zeigt: eine schematische Querschnittansicht einer ersten Ausführungsform der hergestellten Steuergeräteeinheit;
- Fig. 5 zeigt: eine schematische Querschnittsansicht einer zweiten Ausführungsform der hergestellten Steuergeräteeinheit; und
- Fig. 6 zeigt: eine schematische Querschnittsansicht einer dritten Ausführungsform der hergestellten Steuergeräteeinheit.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

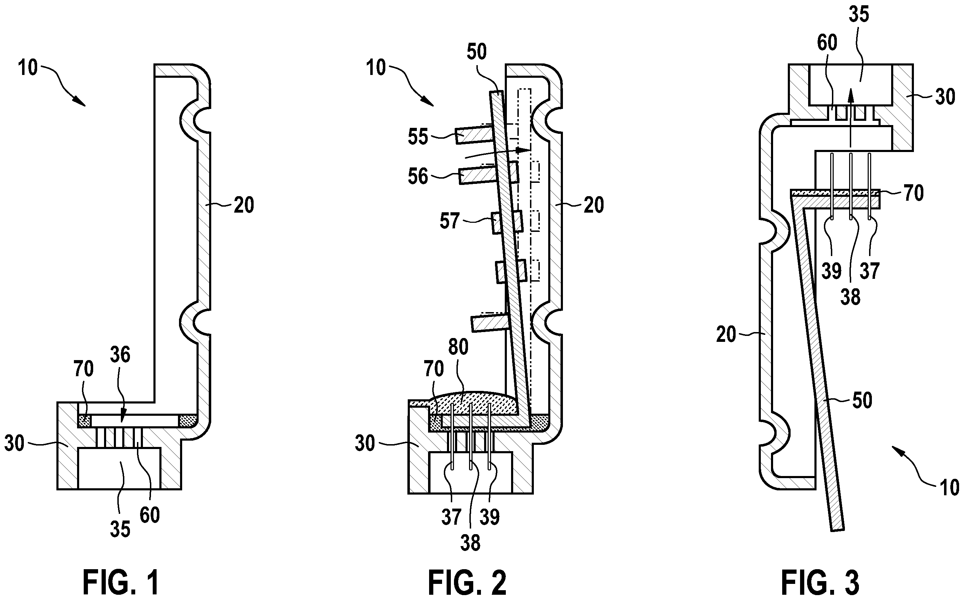

Fig. 1 zeigt eine schematische Querschnittsansicht eines Gehäusebodenelements 20 und eines Steckeraufnahmeelements 30 mit aufgebrachtem erstem Dammmaterial 70 (Dam-Material), wobei das Gehäusebodenelement 20 und das Steckeraufnahmeelement 30 Teile einer Steuergeräteeinheit 10 bilden. Das Gehäusebodenelement 20 und das Steckeraufnahmeelement 30 sind einstückig ausgebildet. Das Steckeraufnahmeelement 30 weist einen Winkel von 90° zu dem Gehäusebodenelement 20 auf. In dem Steckeraufnahmeelement 30 sind Aufnahmeöffnungen 60 zur Aufnahme von Steckerpins 37, 38, 39 vorahnden. Die Aufnahmeöffnungen 60 sind in einem Aufnahmeöffnungsbereich 36 des Steckeraufnahmeelements 30 angeordnet. Die Aufnahmeöffnungen erstrecken sich durch das Steckeraufnahmeelement 30 hindurch. Das Steckeraufnahmeelement 30 weist eine Steckeraufnahme zum Aufnehmen eines Steckers auf.

Um den Aufnahmeöffnungsbereich 36 herum, d.h. den Aufnahmeöffnungsbereich 36 umschließend, ist ein erstes Dammmaterial 70 auf das Steckeraufnahmeelement 30 aufgebracht. Dies wird als umlaufende Raupe von erstem Dammmaterial 70 bezeichnet. Das erste Dammmaterial 70 kann den Aufnahmeöffnungsbereich 36 teilweise oder vollständig umschließen.

Das erste Dammmaterial 70 befindet sich nicht in den Aufnahmeöffnungen 60. Das erste Dammmaterial 70 ist in dem 90°-Winkel-Eck vorhanden, das den Übergang vom Steckeraufnahmeelement 30 zu dem Gehäusebodenelement 20 bildet. Das erste Dammmaterial 70 ist auf die Seite des Steckeraufnahmeelements 30 aufgebracht worden, der der Steckeraufnahmeöffnung 35 gegenüberliegt bzw. hiervon abgewandt ist. Die Steckeraufnahmeöffnung 35 dient zur Aufnahme eines Steckers, der mit den Steckerpins 37, 38, 39 verbunden wird. Das erste Dammmaterial 70 bleibt zunächst unvernetzt, d.h. es wird zunächst nicht ausgehärtet.

Fig. 2 zeigt eine schematische Querschnittsansicht des Gehäusebodenelements 20 und des Steckeraufnahmebereichs aus Fig. 1 nach Anordnen des Leiterplattenelements 50, z.B. eines Printed Circuit Boards, und dem Aufbringen des zweiten Dammmaterials 80 (Dam-Material).

Ein Leiterplattenelement 50, auf dem elektrische Bauelement angeordnet sind, wird in Fig. 2 (durch einen Pfeil angedeutet und die gestrichelte Endposition des Leiterplattenelements 50 angedeutet) in den Gehäuseboden eingesetzt. Das Leiterplattenelement 50 weist in einem Steckerpinbereich Steckerpins 37, 38, 39 auf, die in dem Leiterplattenelement 50 z.B. durch Einlöten oder Einpressen befestigt sind. Das Leiterplattenelement 50 wird derart angeordnet, dass sich die Steckerpins 37, 38, 39 durch die Aufnahmeöffnungen 60 des Steckeraufnahmeelements 30 hindurch erstrecken. Das Leiterplattenelement 50 weist im Querschnitt eine L-förmige Form auf. Beim Einsetzen des Leiterplattenelements 50 kontaktiert die in Fig. 2 linke Kante das erste Dammmaterial 70 und das rechte untere Ende bzw. der Knick des Leiterplattenelements 50 kontaktiert das erste Dammmaterial 70 ebenfalls. Das Leiterplattenelement 50 wird in das erste Dammmaterial 70 hinein gedrückt.

Zweites Dammmaterial 80 wurde auf die in Fig. 2 obere Seite der Steckerpins 37, 38, 39 und die dem Steckerpinbereich entgegengesetzte Seite des Leiterplattenelements 50 aufgebracht. Dies dient bei eingepressten Pins als Steckerpins 37, 38, 39 zur Abdichtung und zur mechanischen Stabilisierung. Bei Lötpins als Steckerpins 37, 38, 39 dient dies zur weiteren Lotstabilisierung. Der Knickbereich des Leiterplattenelements 50, der unter Umständen durch Abfräsen offene Bereiche aufweist, wird durch das erste Dammmaterial 70 und/oder zweite Dammmaterial 80 geschützt.

Vorstellbar ist auch, dass das Steckeraufnahmeelement 30 und das Gehäusebodenelement 20 nicht einen Winkel von 90° bzw. nicht geknickt zueinander sind, und das Leiterplattenelement 50 flach, d.h. nicht geknickt, ausgebildet ist.

Fig. 3 zeigt eine schematische Querschnittsansicht eines Gehäusebodenelements 20 und eines Steckeraufnahmeelements 30, wobei das erste Dämmmaterial 70 auf einen Steckerpinbereich aufgebracht worden ist, wobei das Gehäusebodenelement 20 und das Steckeraufnahmeelement 30 Teile einer Steuergeräteeinheit 10 bilden. Das Aufbringen des ersten Dämmmaterials 70 auf den Steckerpinbereich stellt eine Alternative zu dem in Fig. 1 gezeigten Aufbringen um den Aufnahmeöffnungsbereich 36 herum dar. Vorstellbar ist jedoch auch, dass dies zusätzlich hierzu geschieht.

Das Aufbringen des zweiten Dammmaterials 80 auf den in Fig. 3 gezeigten Steckerpinbereich kann wie in Fig. 2 gezeigt bzw. wie im Zusammenhang mit der Fig. 2 beschrieben ausgeführt werden.

Das Steckeraufnahmeelement 30 weist Abstandshalter, z.B. Abstandsnoppen, oder eine Vertiefung mit Anschlag für das Leiterplattenelement 50 auf, damit eine definierte Dicke (in Fig. 2 von oben nach unten verlaufend) des ersten Dammmaterials 70 zwischen dem Leiterplattenelement 50 und dem Steckeraufnahmeelement 30 entsteht und die Steckerpins 37, 38, 39 eine vorbestimmte Position in Bezug auf das Steckeraufnahmeelement 30 einnehmen.

Das erste Dammmaterial 70 gelangt hierbei nicht entlang der Steckerpins 37, 38, 39 in den Steckeraufnahmebereich.

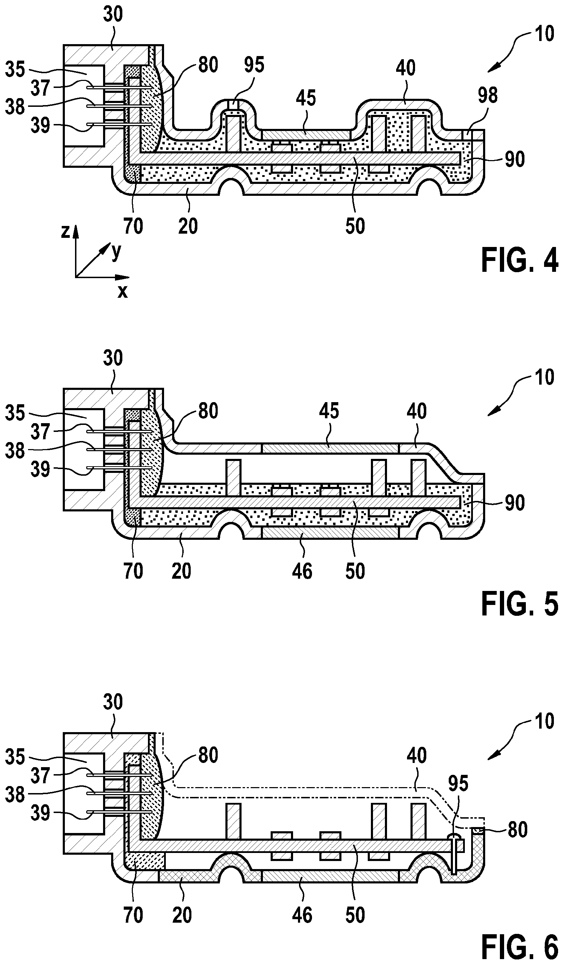

Fig. 4 zeigt eine schematische Querschnittansicht einer ersten Ausführungsform der hergestellten Steuergeräteeinheit 10. Der Gehäusedeckel 40 wurde nach den in Fig. 1 und Fig. 2 bzw. in Fig. 3 gezeigten Schritte (Aufbringen des ersten Dammmaterials 70, Anordnen des Leiterplattenelements 50, Aufbringen des zweiten Dammmaterials 80) derart angeordnet, dass der Gehäusedeckel 40 zusammen mit dem Steckeraufnahmeelement 30 und dem Gehäusebodenelement 20 das Leiterplattenelement 50 umschließt. Zwischen dem Steckeraufnahmeelement 30 und dem Gehäusedeckel 40 ist Dammmaterial 70 und/oder 80 vorhanden und dichtet diesen Bereich öldicht ab. Nun wird Füllmaterial 90 (Fill-Material) durch eine Einfüllöffnung 95 im Gehäusedeckel 40 solange in den Innenraum des Gehäuses, das durch den Gehäusedeckel 40, das Gehäusebodenelement 20 und das Leiterplattenelement 50 begrenzt ist, gefüllt, bis Füllmaterial 90 aus einer Steigeröffnung 98 in dem Gehäusedeckel 40 steigt bzw. gelangt oder bis die Steigeröffnung 98 gefüllt ist. Hierdurch ist nun auch die Verbindung zwischen Gehäusedeckel 40 und Gehäusebodenelement 20 (auf der rechten Seite in Fig. 4) öldicht abgedichtet, nämlich mit Füllmaterial 90. Anschließend werden das erste Dammmaterial 70, das zweite Dammmaterial 80 und das Füllmaterial 90 ausgehärtet, in einem einzigen Aushärtevorgang, z.B. durch Wärme bzw. Hitze (z.B. ca. 40 min bei ca. 120 °C).

Der Gehäusedeckel 40 kann eine Metalleinlage 45, 46 zum Abschwächen von eindringender oder ausgehender elektromagnetischer Strahlung aufweisen. Da der Innenraum vollständig ausgefüllt ist, kann eine sehr dünne Metalleinlage 45, 46 bzw. eine Metalleinlage 45, 46 mit geringem Volumen verwendet werden, da die Wärme durch das Füllmaterial 90 gut abgeleitet wird. Die Metalleinlage 45, 46 bzw. Metallplatte kann mittels einer Insert- oder Outsert-Technik eingespritzt sein. Alternativ kann diese in dem Gehäusedeckel 40 oder in das Gehäusebodenelement 20 nur eingerastet sein und mit Dammmaterial 70, 80 und/oder Füllmaterial 90 vom Innenraum her abgedichtet sein.

Durch das vollständige Ausfüllen des Innenraums kann der Gehäusedeckel 40 dünnwandig und/oder labil ausgebildet sein, da das Füllmaterial 90 die Festigkeit gewährleistet, insbesondere wenn das Füllmaterial 90 Epoxidharz umfasst oder ist. Der Gehäusedeckel 40 hat in diesem Fall nur eine konturgebende Funktion. Der Gehäusedeckel 40 bzw. das Gehäusebodenelement 20 kann bzw. können derart ausgebildet sein, dass der Innenraum möglichst klein ist. Hierdurch wird Material gespart und Entwärmungswege werden verkürzt.

Das Leiterplattenelement 50 kann solange gegen das Gehäusebodenelement 20 gezogen bzw. gedrückt werden, bis das Füllmaterial 90 ausgehärtet ist.

Fig. 5 zeigt eine schematische Querschnittsansicht einer zweiten Ausführungsform der hergestellten Steuergeräteeinheit 10. Hierbei wird Füllmaterial 90 auf das Leiterplattenelement 50 und/oder das Gehäusebodenelement 20 aufgebracht. Dieses fließt, spätestens beim Aushärten, auch in den Bereich zwischen dem Leiterplattenelement 50 und dem Gehäusebodenelement 20 bzw. auf das Leiterplattenelement 50. Das Füllmaterial 90 bedeckt die elektrischen Bauelemente 55, 56, 57 auf dem Leiterplattenelement 50 zumindest teilweise, insbesondere vollständig. Das Füllmaterial 90 wird derart eingebracht, dass eine Kante bzw. ein Bereich des Gehäusebodenelements 20, die bzw. der nachfolgend in Kontakt mit dem Gehäusedeckel 40 gelangt, auch von Füllmaterial 90 bedeckt ist.

Nun wird der Gehäusedeckel 40 aufgesetzt bzw. angeordnet. Der Gehäusedeckel 40 berührt mit seinem linken Ende in Fig. 5 das zweite Dammmaterial 80 an dem Steckeraufnahmeelement 30 und mit seinem rechten Ende in Fig. 5 das Füllmaterial 90 an dem Gehäusebodenelement 20. Somit wird eine öldichte Verbindung zwischen Gehäusedeckel 40 und Gehäusebodenelement 20 und zwischen Gehäusedeckel 40 und Steckeraufnahmeelement 30 erreicht.

Anschließend werden das erste Dämmmaterial 70, das zweite Dämmmaterial 80 und das Füllmaterial 90 in einem Vorgang ausgehärtet, z.B. durch Wärme bzw. Hitze oder UV-Strahlung. In Fig. 5 ist nicht das gesamte Innenvolumen mit Füllmaterial 90 bzw. Dämmmaterial 70, 80 gefüllt, sondern es ist zwischen dem Leiterplattenelement 50 und dem Gehäusedeckel 40 ein Hohlraum vorhanden.

Im Gehäusedeckel 40 und im Gehäusebodenelement 20 ist jeweils eine Metalleinlage 45, 46 vorhanden.

Fig. 6 zeigt eine schematische Querschnittsansicht einer dritten Ausführungsform der hergestellten Steuergeräteeinheit 10. Das Gehäusebodenelement 20 und das Steckeraufnahmeelement 30 sind zweistückig ausgebildet. Die Verbindung zwischen diesen beiden Elementen wird über das erste Dammmaterial 70 hergestellt bzw. abgedichtet. Bei der in Fig. 6 gezeigten Ausführungsform wird kein Füllmaterial 90 verwendet, sondern nur ein erstes Dammmaterial 70 und ein zweites Dammmaterial 80 wie bei den in den Fig. 1-5 gezeigten Ausführungsformen. Das Leiterplattenelement 50 ist über einen Befestigungspin 99 mit dem Gehäusebodenelement 20 verbunden. Der Befestigungspin 99 kann aus Kunststoff bestehen (sogenannter Warmniet).

Durch die Zweistückigkeit des Steckeraufnahmeelements 30 und des Gehäusebodenelements 20 im Sinne eines Baukastens können Steckersubmodule mit z.B. je 50 Kontakten bzw. Steckerpins 37, 38, 39 zu Gesamtsteckern mit z.B. 50, 100, 150 oder 200 Kontakten bzw. Steckerpins 37, 38, 39 kombiniert werden.

Das Steckeraufnahmeelement 30 kann z.B. Polyamid mit Glasfaserfüllung umfassen. Dieser Kunststoff hat in Längsrichtung (Richtung der Glasfaserausrichtung) einen Wärmeausdehnungskoeffizienten im Bereich von ca. 20 ppm/K, wenn z.B. PA66 mit 35% Glasfaseranteil verwendet wird. Das Leiterplattenelement 50 hat einen Wärmeausdehnungskoeffizienten (CTE) im Bereich von ca. 15 ppm/K bis ca. 20 ppm/K, so dass mit einer Epoxidharzmasse mit einem Wärmeausdehnungskoeffizienten im Bereich von ca. 15 ppm/K bis ca. 20 ppm/K als Dammmaterial 70, 80 und/oder als Füllmaterial 90 keine schädlichen thermomechanischen Spannungen zwischen dem Steckeraufnahmeelement 30, dem Dammmaterial 70, 80/Füllmaterial 90 und dem Leiterplattenelement 50 auftreten.

Wird die Steckerbreite (Breite des Steckeraufnahmeelement 30 in γ-Richtung; in Fig. 4 und in Fig. 5 verläuft die γ-Richtung in die Zeichenebene hinein) über die Anspritzpunkte derart hergestellt, dass dies der Glasfaserrichtung entsprechen, wird eine Delamination wegen eines Wärmeausdehnungskoeffizienten von ca. 200 ppm/K auch über einen breiten Stecker vermieden. Quer zur Glasfasserrichtung mit einem Wärmeausdehnungskoeffizienten von ca. 60 ppm/K erstrecken sich dann die Höhe (z-richtung; in Figur 4 und in Fig. 5 von unten nach oben), die aufgrund des kleinen absoluten Maßes unkritisch ist, und die Tiefe (x-Richtung; in Fig. 4 und in Fig. 5 von links nach rechts) des Steckers bzw. des Steckeraufnahmeelements 30.

Die Metalleinlage 45, 46 kann Aluminium umfassen, das Aluminium mit einem Wärmeausdehnungskoeffizienten von ca. 20 ppm/K bis ca. 23 ppm/K gut mit dem Wärmeausdehnungskoeffizienten des Füllmaterials 90 und mit dem Wärmeausdehnungskoeffizienten des Leiterplattenelements 50, die im Bereich von ca. 15 ppm/K bis ca. 20 ppm/K liegen, übereinstimmen, also delaminationsfrei verbindbar sind.

Die Verbindung zwischen der in Fig. 6 linken Seite des Gehäusedeckels 40 und dem Steckeraufnahmeelement 30 wird durch das zweite Dammmaterial 80 abgedichtet. Die Verbindung zwischen der in Fig. 6 rechten Seite des Gehäusedeckels 40 und dem Gehäusebodenelement 20 wird durch eine umlaufende Raupe aus erstem Dämmmaterial 70 und/oder zweitem Dämmmaterial 80 öldicht abgedichtet.

Die Steckerpins 37, 38, 39 dienen zum Verbinden mit einem Stecker. Jeder der Steckerpins 37, 38, 39 ist mit einem oder mehreren der elektrischen Bauelemente 55, 56, 57 elektrisch verbunden.

Die Steuergeräteeinheit 10 kann ein Getriebe, eine Lenkung oder ähnliches steuern bzw. regeln, z.B. in einem Fahrzeug.

Der Gehäusedeckel 40 und/oder das Gehäusebodenelement 20 kann Kunststoffmaterial, Metall/Metalllegierung oder eine Kombination hiervon umfassen oder hieraus bestehen.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Verfahren zum Herstellen einer Steuergeräteeinheit (10), insbesondere für ein Fahrzeug, folgende Schritte umfassend:
Bereitstellen eines Gehäusebodenelements (20);
Bereitstellen eines Steckeraufnahmeelements (30) zum Aufnehmen eines Steckers, wobei das Steckeraufnahmeelement (30) in einem Aufnahmeöffnungsbereich (36) Aufnahmeöffnungen (60) für Steckerpins (37, 38, 39) aufweist;
Bereitstellen eines Leiterplattenelements (50), wobei das Leiterplattenelement (50) elektrische Bauelemente (55, 56, 57) auf einer Montagefläche und in dem Leiterplattenelement (50) befestigte Steckerpins (37, 38, 39) umfasst, wobei die Steckerpins (37, 38, 39) aus einem Steckerpinbereich des Leiterplattenelements (50) hervorstehen;
Anordnen des Leiterplattenelements (50) auf dem Gehäusebodenelement (20) und auf dem Steckeraufnahmeelement (30) derart, dass sich die Steckerpins (37, 38, 39) durch die Aufnahmeöffnungen (60) des Steckeraufnahmeelements (30) erstrecken;
Aufbringen eines zweiten Dammmaterials (80) auf das Steckeraufnahmeelement (30) und auf eine der Seite des Steckerpinbereichs gegenüberliegende Seite des Leiterplattenelements (50); und
Anordnen eines Gehäusedeckels (40) derart, dass der Gehäusedeckel (40), das Gehäusebodenelement (20) und das Steckeraufnahmeelement (30) zusammen das Leiterplattenelement (50) umschließen und der Gehäusedeckel (40) mit dem Steckeraufnahmeelement (30) mittels des zweiten Dammmaterials (80) öldicht verbunden ist, **gekennzeichnet durch** die Schritte des Aufbringens eines ersten Dammmaterials (70) auf das Steckeraufnahmeelement (30) zumindest teilweise, insbesondere vollständig, um den Aufnahmeöffnungsbereich (36) des Steckeraufnahmeelements (30) herum oder auf den Steckerpinbereich des Leiterplattenelements (50), wobei das erste und zweite Dammmaterial (70, 80) ausgehärtet wird, nachdem der Gehäusedeckel (40) angeordnet wurde, und wobei das Steckeraufnahmeelement (30) senkrecht zu dem Gehäusebodenelement (20) verläuft und das Leiterplattenelement (50) zwei Teilbereiche hat, die einen Winkel von ca. 90° zueinander aufweisen.

2. Verfahren nach Anspruch 1, ferner folgenden Schritt umfassend:
Aufbringen eines Füllmaterials (90) auf das Leiterplattenelement (50), wobei der Gehäusedeckel (40) derart angeordnet wird, dass der Gehäusedeckel (40), das Gehäusebodenelement (20) und das Steckeraufnahmeelement (30) zusammen das Leiterplattenelement (50) umschließen und der Gehäusedeckel (40) mit dem Gehäusebodenelement (20) mittels des Füllmaterials (90) öldicht verbunden ist und der Gehäusedeckel (40) mit dem Steckeraufnahmeelement (30) mittels des zweiten Dammmaterials (80) öldicht verbunden ist.

3. Verfahren nach Anspruch 1 oder 2, wobei
zuerst der Gehäusedeckel (40) angeordnet wird und dann über eine Einfüllöffnung (95) im Gehäusedeckel (40) Füllmaterial (90) in den vom Gehäusedeckel (40), dem Gehäusebodenelement (20) und dem Steckeraufnahmeelement (30) umschlossenen Innenraum eingebracht wird, insbesondere solange bis Füllmaterial (90) aus einer Steigeröffnung (98) in dem Gehäusedeckel (40) gelangt.

4. Verfahren nach Anspruch 2 oder 3, wobei das Füllmaterial (90) zusammen mit dem ersten und zweiten Dammmaterial (70, 80) ausgehärtet wird, nachdem der Gehäusedeckel (40) angeordnet wurde.

5. Verfahren nach einem der vorhergehenden Ansprüche, wobei
das Leiterplattenelement (50) eine L-förmige Querschnittsform aufweist.

6. Verfahren nach einem der vorhergehenden Ansprüche, wobei
das Steckeraufnahmeelement (30) einstückig mit dem Gehäusebodenelement (20) ausgebildet ist.

7. Verfahren nach einem der vorhergehenden Ansprüche, wobei
der Gehäusedeckel (40) und/oder das Gehäusebodenelement (20) jeweils eine Metalleinlage (45, 46) aufweisen.

8. Steuergeräteeinheit (10), insbesondere für ein Fahrzeug,
umfassend:
ein Gehäusebodenelement (20);
ein Steckeraufnahmeelement (30) zum Aufnehmen eines Steckers, wobei das Steckeraufnahmeelement (30) in einem Aufnahmeöffnungsbereich (36) Aufnahmeöffnungen (60) für Steckerpins (37, 38, 39) aufweist;
einen Gehäusedeckel (40), und
ein Leiterplattenelement (50), wobei das Leiterplattenelement (50) elektrische Bauelemente (55, 56, 57) auf einer Montagefläche und in dem Leiterplattenelement (50) befestigte Steckerpins (37, 38, 39) umfasst, wobei die Steckerpins (37, 38, 39) aus einem Steckerpinbereich des Leiterplattenelements (50) hervorstehen, wobei das Leiterplattenelement (50) auf dem Gehäusebodenelement (20) und auf dem Steckeraufnahmeelement (30) derart angeordnet ist, dass sich die Steckerpins (37, 38, 39) durch die Aufnahmeöffnungen (60) des Steckeraufnahmeelements (30) erstrecken,
wobei ein zweiten Dammmaterials (80) auf das Steckeraufnahmeelement (30) und auf eine der Seite des Steckerpinbereichs gegenüberliegende Seite des Leiterplattenelements (50) aufgebracht ist und
wobei der Gehäusedeckel (40), das Gehäusebodenelement (20) und das Steckeraufnahmeelement (30) zusammen das Leiterplattenelement (50) umschließen, und der Gehäusedeckel (40) mit dem Steckeraufnahmeelement (30) mittels des zweiten Dammmaterials (80) öldicht verbunden ist
**dadurch gekennzeichnet, dass**
ein erstes Dammmaterials (70) auf das Steckeraufnahmeelement (30) zumindest teilweise, insbesondere vollständig, um den Aufnahmeöffnungsbereich (36) des Steckeraufnahmeelements (30) herum oder auf den Steckerpinbereich des Leiterplattenelements (50) aufgebracht ist, wobei das Steckeraufnahmeelement (30) senkrecht zu dem Gehäusebodenelement (20) verläuft und das Leiterplattenelement (50) zwei Teilbereiche hat, die einen Winkel von ca. 90° zueinander aufweisen.

9. Steuergeräteeinheit (10) nach Anspruch 8, wobei
der Innenraum derart vollständig mit Dammmaterial (70, 80) und/oder Füllmaterial (90) gefüllt ist, dass im Wesentlichen keine Hohlräume in dem Innenraum mehr vorhanden sind.

## Claims

1. Method for producing a control device unit (10), in particular for a vehicle, comprising the following steps:
providing a housing base element (20);
providing a connector receiving element (30) for receiving a connector, wherein the connector receiving element (30) has, in a receiving opening region (36), receiving openings (60) for connector pins (37, 38, 39);
providing a circuit board element (50), wherein the circuit board element (50) comprises electrical components (55, 56, 57) on a mounting surface and connector pins (37, 38, 39) fastened in the circuit board element (50), wherein the connector pins (37, 38, 39) protrude from a connector pin region of the circuit board element (50);
arranging the circuit board element (50) on the housing base element (20) and on the connector receiving element (30) in such a way that the connector pins (37, 38, 39) extend through the receiving openings (60) of the connector receiving element (30);
applying a second insulating material (80) to the connector receiving element (30) and to a side of the circuit board element (50) that is situated opposite the side of the connector pin region; and
arranging a housing cover (40) in such a way that the housing cover (40), the housing base element (20) and the connector receiving element (30) together surround the circuit board element (50) and the housing cover (40) is connected in an oil-tight manner to the connector receiving element (30) by means of the second insulating material (80), **characterized by** the steps of applying a first insulating material (70) to the connector receiving element (30) at least partially, in particular completely, around the receiving opening region (36) of the connector receiving element (30) or to the connector pin region of the circuit board element (50), wherein the first and the second insulating materials (70, 80) are cured after the housing cover (40) has been arranged, and wherein the connector receiving element (30) runs perpendicularly to the housing base element (20) and the circuit board element (50) has two subregions which are at an angle of approximately 90° in relation to one another.

2. Method according to Claim 1, further comprising the following step:
applying a filling material (90) to the circuit board element (50), wherein the housing cover (40) is arranged in such a way that the housing cover (40), the housing base element (20) and the connector receiving element (30) together surround the circuit board element (50) and the housing cover (40) is connected in an oil-tight manner to the housing base element (20) by means of the filling material (90) and the housing cover (40) is connected in an oil-tight manner to the connector receiving element (30) by means of the second insulating material (80).

3. Method according to Claim 1 or 2, wherein
first the housing cover (40) is arranged and then filling material (90) is introduced into the interior space surrounded by the housing cover (40), the housing base element (20) and the connector receiving element (30) via a filling opening (95) in the housing cover (40), in particular until filling material (90) passes out of a riser opening (98) in the housing cover (40).

4. Method according to Claim 2 or 3, wherein the filling material (90) is cured together with the first and the second insulating materials (70, 80) after the housing cover (40) has been arranged.

5. Method according to one of the preceding claims, wherein the circuit board element (50) has an L-shaped cross-sectional shape.

6. Method according to one of the preceding claims, wherein the connector receiving element (30) is formed in one piece with the housing base element (20).

7. Method according to one of the preceding claims, wherein the housing cover (40) and/or the housing base element (20) each have a metal inlay (45, 46).

8. Control device unit (10), in particular for a vehicle, comprising:
a housing base element (20);
a connector receiving element (30) for receiving a connector, wherein the connector receiving element (30) has, in a receiving opening region (36), receiving openings (60) for connector pins (37, 38, 39);
a housing cover (40); and
a circuit board element (50), wherein the circuit board element (50) comprises electrical components (55, 56, 57) on a mounting surface and connector pins (37, 38, 39) fastened in the circuit board element (50), wherein the connector pins (37, 38, 39) protrude from a connector pin region of the circuit board element (50), wherein the circuit board element (50) is arranged on the housing base element (20) and on the connector receiving element (30) in such a way that the connector pins (37, 38, 39) extend through the receiving openings (60) of the connector receiving element (30),
wherein a second insulating material (80) is applied to the connector receiving element (30) and to a side of the circuit board element (50) that is situated opposite the side of the connector pin region, and
wherein the housing cover (40), the housing base element (20) and the connector receiving element (30) together surround the circuit board element (50), and the housing cover (40) is connected in an oil-tight manner to the connector receiving element (30) by means of the second insulating material (80),
**characterized in that**
a first insulating material (70) is applied to the connector receiving element (30) at least partially, in particular completely, around the receiving opening region (36) of the connector receiving element (30) or to the connector pin region of the circuit board element (50), wherein the connector receiving element (30) runs perpendicularly to the housing base element (20) and the circuit board element (50) has two subregions which are at an angle of approximately 90° in relation to one another.

9. Control device unit (10) according to Claim 8, wherein the interior space is completely filled with insulating material (70, 80) and/or filling material (90) in such a way that there are substantially no more cavities in the interior space.

## Revendications

1. Procédé de fabrication d'une unité appareil de commande (10), en particulier pour un véhicule, comportant les étapes suivantes :
fourniture d'un élément de fond de boîtier (20) ;
fourniture d'un élément de réception de connecteur (30) servant à la réception d'un connecteur, l'élément de réception de connecteur (30) comprenant, dans une région d'ouvertures de réception (36), des ouvertures de réception (60) pour des broches de connecteur (37, 38, 39) ;
fourniture d'un élément de carte de circuits imprimés (50), l'élément de carte de circuits imprimés (50) comportant des composants électriques (55, 56, 57) sur une surface de montage et des broches de connecteur (37, 38, 39) fixées dans l'élément de carte de circuits imprimés (50), les broches de connecteur (37, 38, 39) faisant saillie à partir d'une région de broches de connecteur de l'élément de carte de circuits imprimés (50) ;
agencement de l'élément de carte de circuits imprimés (50) sur l'élément de fond de boîtier (20) et sur l'élément de réception de connecteur (30), de telle sorte que les broches de connecteur (37, 38, 39) s'étendent à travers les ouvertures de réception (60) de l'élément de réception de connecteur (30) ;
application d'un deuxième matériau isolant (80) sur l'élément de réception de connecteur (30) et sur un côté de l'élément de carte de circuits imprimés (50) opposé au côté de la région de broches de connecteur ; et
agencement d'un couvercle de boîtier (40) de telle sorte que le couvercle de boîtier (40), l'élément de fond de boîtier (20) et l'élément de réception de connecteur (30) entourent ensemble l'élément de carte de circuits imprimés (50) et que le couvercle de boîtier (40) soit relié de manière étanche à l'huile à l'élément de réception de connecteur (30) au moyen du deuxième matériau isolant (80), **caractérisé par** les étapes d'application d'un premier matériau isolant (70) sur l'élément de réception de connecteur (30) au moins partiellement, en particulier complètement, autour de la région d'ouvertures de réception (36) de l'élément de réception de connecteur (30) ou sur la région de broches de connecteur de l'élément de carte de circuits imprimés (50), le premier et le deuxième matériau isolant (70, 80) étant durcis, après que le couvercle de boîtier (40) a été agencé, et l'élément de réception de connecteur (30) s'étendant perpendiculairement à l'élément de fond de boîtier (20) et l'élément de carte de circuits imprimés (50) ayant deux régions partielles qui forment un angle d'approximativement 90° l'une par rapport à l'autre.

2. Procédé selon la revendication 1, comportant en outre l'étape suivante :
application d'un matériau de remplissage (90) sur l'élément de carte de circuits imprimés (50), le couvercle de boîtier (40) étant agencé de telle sorte que le couvercle de boîtier (40), l'élément de fond de boîtier (20) et l'élément de réception de connecteur (30) entourent ensemble l'élément de carte de circuits imprimés (50) et que le couvercle de boîtier (40) soit relié de manière étanche à l'huile à l'élément de fond de boîtier (20) au moyen du matériau de remplissage (90) et que le couvercle de boîtier (40) soit relié de manière étanche l'huile à l'élément de réception de connecteur (30) au moyen du deuxième matériau isolant (80).

3. Procédé selon la revendication 1 ou 2,
le couvercle de boîtier (40) étant tout d'abord agencé et ensuite du matériau de remplissage (90) étant introduit dans l'espace intérieur entouré par le couvercle de boîtier (40), l'élément de fond de boîtier (20) et l'élément de réception de connecteur (30) via une ouverture de remplissage (95) dans le couvercle de boîtier (40), en particulier jusqu'à ce que le matériau de remplissage (90) parvienne dans le couvercle de boîtier (40) à partir d'une ouverture formant évent (98).

4. Procédé selon la revendication 2 ou 3,
le matériau de remplissage (90) étant durci conjointement avec le premier et le deuxième matériau isolant (70, 80), après que le couvercle de boîtier (40) a été agencé.

5. Procédé selon l'une des revendications précédentes, l'élément de carte de circuits imprimés (50) présentant une forme en section transversale en forme de L.

6. Procédé selon l'une des revendications précédentes, l'élément de réception de connecteur (30) étant réalisé d'une seule pièce avec l'élément de fond de boîtier (20).

7. Procédé selon l'une des revendications précédentes, le couvercle de boîtier (40) et/ou l'élément de fond de boîtier (20) comprenant respectivement un insert métallique (45, 46).

8. Unité appareil de commande (10), en particulier pour un véhicule,
comportant :
un élément de fond de boîtier (20) ;
un élément de réception de connecteur (30) servant à la réception d'un connecteur, l'élément de réception de connecteur (30) comprenant, dans une région d'ouvertures de réception (36), des ouvertures de réception (60) pour des broches de connecteur (37, 38, 39) ;
un couvercle de boîtier (40), et
un élément de carte de circuits imprimés (50), l'élément de carte de circuits imprimés (50) comportant des composants électriques (55, 56, 57) sur une surface de montage et des broches de connecteur (37, 38, 39) fixées dans l'élément de carte de circuits imprimés (50), les broches de connecteur (37, 38, 39) faisant saillie à partir d'une région de broches de connecteur de l'élément de carte de circuits imprimés (50), l'élément de carte de circuits imprimés (50) étant agencé sur l'élément de fond de boîtier (20) et sur l'élément de réception de connecteur (30), de telle sorte que les broches de connecteur (37, 38, 39) s'étendent à travers les ouvertures de réception (60) de l'élément de réception de connecteur (30),
un deuxième matériau isolant (80) étant appliqué sur l'élément de réception de connecteur (30) et sur un côté de l'élément de carte de circuits imprimés (50) opposé au côté de la région de broches de connecteur et
le couvercle de boîtier (40), l'élément de fond de boîtier (20) et l'élément de réception de connecteur (30) entourant ensemble l'élément de carte de circuits imprimés (50), et le couvercle de boîtier (40) étant relié de manière étanche à l'huile à l'élément de réception de connecteur (30) au moyen du deuxième matériau isolant (80),
**caractérisé en ce**
**qu'**un premier matériau isolant (70) est appliqué sur l'élément de réception de connecteur (30) au moins partiellement, en particulier complètement, autour de la région d'ouvertures de réception (36) de l'élément de réception de connecteur (30) ou sur la région de broches de connecteur de l'élément de carte de circuits imprimés (50), l'élément de réception de connecteur (30) s'étendant perpendiculairement à l'élément de fond de boîtier (20) et l'élément de carte de circuits imprimés (50) ayant deux régions partielles qui forment un angle d'approximativement 90° l'une par rapport à l'autre.

9. Unité appareil de commande (10) selon la revendication 8,
l'espace intérieur étant rempli complètement de matériau isolant (70, 80) et/ou de matériau de remplissage (90), de sorte que sensiblement aucune cavité ne soit plus présente dans l'espace intérieur.
